# EUROPEAN PATENT APPLICATION

(11) **EP 1 698 405 A1**
(43) Date of publication of application: **06.09.2006**
(21) Application number: 06004393.2
(22) Date of filing: 03.03.2006
(51) Int. Cl.: B08B 7/00

(54) **Method for removing a residue from a chamber**

(30) Priority: 03.03.2005 US 70994
(71) Applicant: Air Products and Chemicals, Inc., Allentown, PA 18195-1501 (US)
(72) Inventor: Vrtis, Raymond Nicholas, Orefield, PA 18069 (US); Lukas, Aaron Scott, Washington, DC 20011 (US); O'Neill, Mark Leonard, Allentown, PA 18104 (US); Bitner, Mark Daniel, Nazareth, PA 18064 (US); Xiang, Xiaohai, Richmond, CA 94804 (US); Karwacki, Eugene Joseph, Jr., Orefield, PA 18069 (US)
(74) Representative: Kador & Partner

(57) **Abstract**

A method for removing a residue from a surface is disclosed herein. In one aspect, the method includes: providing a chamber containing the surface coated with the residue; providing in the chamber a cleaning composition of an oxidizing gas and optionally an organic species; and irradiating the cleaning composition with ultraviolet light to remove the residue from the surface. The surface can be, for example, a window of a processing chamber. In certain aspects, a reflective surface can be located within close proximity to the window to enhance cleaning efficiency.

## Description

### BACKGROUND OF THE INVENTION

During the deposition of a desired film and/or the modification of film composition or properties, either energetic or chemical, of a given material there is frequently an undesired residue, that is formed along with the desired material. In order to avoid process deviation or particle formation, referred to as "flaking", a cleaning process may be employed to remove the undesirable residue(s). This residue can be cleaned in a physical manner, commonly called a "wet clean" because the equipment is physically disassembled and cleaned with a liquid solvent or an abrasive. Such wet-cleans are typically undesirable due to the down-time associated with the equipment disassembly and re-assembly. It is considered advantageous if the cleaning process can be performed without having to disassemble the equipment.

In one such example, UV-assisted Chemical Vapor Depositions (CVD) is generally performed in a chamber equipped with a window through which UV radiation is transmitted. A substrate is placed into the chamber and specific chemical species are introduced that react when exposed to UV radiation. The UV source is then energized and the UV light enters the chamber through the transmission window, activating the process gases, resulting in the deposition of a desired film. This deposition process is generally non-selective to the substrate; thus, film deposition occurs not only on the desired substrate but also on the transmission window as well as the chamber walls. In general, any film deposited on the transmission window will absorb UV light, resulting in a gradual decrease in intensity of the UV light passing through the transmission window into the CVD chamber. After a period of time, the UV transmission through the window will decrease sufficiently to affect the deposition process, necessitating cleaning or replacement of the window.

In UV annealing, or curing, a film is placed into the chamber and exposed to UV irradiation causing a desirable change to occur in that film. During this process, species may be liberated from the film that can deposit onto the UV transmission window and chamber walls. This deposition onto the transmission window can cause a decrease in UV transmission through the window. For example, a substrate having a film deposited thereupon composed of porogen and organosilicate may be placed into a chamber and exposed to UV light for the purpose of modifying the film properties. As the porogen is liberated from the film when exposed to UV radiation, a residue condenses on the interior surfaces of the treatment chamber, including the transmission window. After a certain number of films are processed, the porogen residue deposited on the transmission window will result in attenuation of the UV radiation, thus affecting post-anneal film properties.

Many techniques have been developed that strive to remove or clean the residue deposited on the transmission window from either photo-CVD or UV processing. For example, EP 1230989 A2 teaches that an organic film residue deposited on an optical element can be removed by exposure to UV light in the presence of oxygen and nitrogen or air. This reference teaches that the oxygen will produce ozone gas when exposed to UV light that then reacts with the organic residue on the optical element. Other examples where ozone and UV light are used to clean organic residues from optical lenses include: EP 1230989 A2, U.S. Patent Application Publication No. 2001/026354 A1, JP 2003344601 A2, and WO 03/062166 that discuss using ozone UV treatment to assist in cleaning organic residues.

The references JP 11339573 A2, JP 11337714 A2, JP 09120950 A2, JP 64004024 A2, and JP 06181200 A2 teach that a combination of ozone and UV light can remove organic materials from surfaces by decomposing the ozone into a reactive "O" radicals and oxygen.

U.S. Patent No. 3,664,899 teaches that UV irradiation in the range of 180 - 300 nanometers (nm) in the presence of at least 1 Torr partial pressure O₂ will effectively remove organic polymer films from substrates. The organic polymer films selected were said to be predisposed to absorb UV light and react with O₂.

U.S. Patent Application Publication No. 2003/0064324 teaches that conjugated organic polymers that absorb UV light can be removed in the absence of oxidizing gases by exposure to UV light in the 180-300 nm range while providing heat to the substrate. The organic species being removed are cited as being of a nature such that they are predisposed to absorb UV light and decompose.

In U.S. Patent No. 4,816,294, Tsuo et al. teach the procedure of using fluorine-containing etching gases along with UV exposure to remove silicon containing residue from the window in a Photo-CVD chamber, as well as using chlorine-containing gases in the presence of UV light to remove aluminum-containing residues from the window in a Photo-CVD chamber. The UV light is used to activate the fluorine-containing or chlorine-containing gases to generate halogen radical species, which then act as the active etching species.

Other methods for minimizing or removing film deposition on optical elements are taught in references such as: U.S. Patent No. 5,810,930, which teaches a method of exchanging an optical window that is coated with residue resulting from a photo-CVD reaction with a clean optical window without exposing the photo-CVD reaction chamber or the apparatus used to accomplish the exchange to air; and U.S. Patent No. 5,005,519, which describes a process by which a curtain of inert gas is passed over the window during UV treatment in a photo-assisted CVD process to prevent residue from depositing.

Regarding the deposition of organic residue onto the chamber walls and transmission window during UV annealing of an inorganic/organic composite film, currently there is no effective way to clean the transmission window in-situ under vacuum after UV annealing of porogen and organosilicate composite films. This lack of an in-situ clean necessitates manual cleaning of the windows. Manual cleaning requires opening up the chamber and cleaning the window with a scrubbing pad and possibly a solvent as well, which is time consuming, impractical, and not as thorough in a production environment.

### BRIEF SUMMARY OF THE INVENTION

A method for removing a residue from a surface is described herein. In one aspect, there is provided a method comprising: providing a chamber containing the surface coated with the residue; introducing into the chamber a cleaning composition comprising an oxidizing gas, an organic species, and optionally a diluent gas; and exposing at least a portion of the cleaning composition to an energy source comprising ultraviolet light to provide active species wherein the active species react with at least a portion of the residue and remove the residue from the surface.

In another aspect, there is provided a method for removing a residue from a surface of a window of a chamber comprising: providing the chamber comprising the window with the surface and a reflective substrate that is located in close proximity to the chamber; introducing into the chamber a cleaning composition comprising an oxidizing gas, optionally an organic species, and optionally a diluent gas; and passing ultraviolet light through the window and onto the reflective substrate such that at least a portion of the ultraviolet light passing through the window is reflected back to the transmission window wherein the ultraviolet light activates the cleaning composition to form active species which react with the residue so as to remove the residue from the surface.

In yet another aspect, there is provided a method for removing a residue from a surface comprising: providing a chamber containing the surface coated with the residue; introducing into the chamber a cleaning composition comprising an oxidizing gas, an organic species, and optionally a diluent gas; and exposing at least a portion of the cleaning composition to an energy source to provide active species wherein the active species react with at least a portion of the residue and remove the residue from the surface.

### DETAILED DESCRIPTION OF THE INVENTION

Disclosed herein is a method of removing residue build-up deposited on the inside of a chamber used in processes such as Chemical Vapor Deposition (CVD) or annealing or curing.

In one aspect, the residue being cleaned is formed during the removal of the porogen from a composite film comprising an OSG-containing structure forming phase and at least one porogen. Optionally, the porogen can be removed from the composite film using an energy source, such as, for example, an electron-beam.

The composite film may be formed by CVD, more specifically plasma enhanced CVD, or alternatively by spin-on techniques. Examples of spin-on composite materials include but are not limited to mesoporous silicate materials such as MesoELK™ or other spin-on materials.

The porogen may be any number of species which will become volatile when exposed to an energy source. In one embodiment, such as composite films that are deposited by a CVD process, the porogen is an organic species which may be introduced into the reaction chamber are organic materials such as saturated or unsaturated, cyclic or linear, aliphatic and aromatic hydrocarbons, e.g., alpha-terpinene and limonene, and as saturated or unsaturated, cyclic or linear, aliphatic and aromatic oxygenated hydrocarbons, e.g., cyclohexanone and cyclohexene oxide. In an alternative embodiment, such as composite films that are deposited by spin-on techniques, the porogen material may also be a preformed organic material. Examples of preformed organic material include: thermally labile polymers such as polyadamantylethylene etc, dendrimers, or large organic molecules. In yet other embodiments, the porogen material may be chemically connected to the silicon atoms in an organosilicate film or a porogenated-precursor. Examples of this include but are not limited to bulky organic groups such as neohexyl, adamantyl, tertiary-butyl, and cyclohexyl groups.

The removal of the porogen is achieved by providing energy to the composite films such that the porogen is released from the film. The energy sources used to remove the porogen include, but are not limited to, thermal energy, a RF generated plasma energy, a remote RF generated plasma energy, alpha-particles, beta-particles, gamma-rays, x-rays, electron beam sources of energy; ultraviolet (10-400 nm), visible (400-750 nm), infrared (750-10,000 nm), microwave, and radio frequency wavelengths of energy, or mixtures thereof.

In one embodiment, the porogen removal from the OSG/porogen composite is achieved by irradiating the composite film with UV energy. Examples of porogen removal using an ultraviolet light and other energy sources is described in copending U.S. Patent Application Publications Nos. 2004/0096672 and 2004/0096593. The process of UV annealing or UV curing is generally carried out in a chamber equipped with a transmission window to allow for the transmission of the UV radiation into the chamber. Due to the nature of the UV assisted process, there may be a tendency for a residue to build up on the transmission window. The residue on the transmission window acts as a filter which may decrease the intensity of UV irradiation through the transmission window into the UV apparatus chamber. This residue should be removed from the transmission window to avoid a change in UV intensity that would result in process drift. Further, continued exposure of the residue to the energy supplied to remove the porogen may make the residue more robust and thus more difficult to remove.

Thus, certain embodiments of the method disclosed herein comprise removing a residue from a transmission window of a chamber, wherein the residue is provided on the window as a byproduct of performing annealing an inorganic/organic composite film within the chamber, and wherein the residue is removed from the surface sufficiently to permit further performance of the annealing process. In certain embodiments, the energy source used to anneal and/or deposit the composite film is also used as the energy source for chamber cleaning.

In order to remove the residue, a cleaning composition is introduced into the chamber. The cleaning composition comprises at least one oxidizing gas, optionally at least one organic species, and optionally a diluent gas. These ingredients may be delivered to the chamber singly or as a pre-mixed single source. Preferred oxidizing gases include, but are not limited to, air, NO, N₂O, NO₂, O₂, NF₃, CIF₃, and CF₂(OF)₂, O₃, and mixtures thereof.

In certain embodiments, the cleaning composition may contain one or more organic species. The organic species is an organic compound that differs from that used as the porogen in the composite film. Examples of organic species that may be used, include but are not limited to, a hydrocarbon, a alcohol, a ketone, a aldehyde, an ether, a carboxylic acid, an ester, an acid anhydride, and/or a diketone. The foregoing organic species may be linear, branched, saturated or unsaturated, cyclic or linear, aliphatic or aromatic.

In one embodiment, the organic species may a linear or branched or a cyclic alcohol having the chemical formulas CₓH₍₂ₓ₊₂₎O or CₓH₂ₓO, respectively, wherein x is a number ranging from 1 to 6. Specific examples of alcohols having either formula include methanol, ethanol, or isopropanol.

In another embodiment, the organic species may be a linear or branched ketone having the formula CᵤH₂ᵤO, a cyclic ketone having the formula CᵤH₍₂ᵤ₋₂₎O, respectively, wherein u is a number ranging from 3 to 6. Specific examples of ketones having either formula include acetone, methylethylketone, cyclopentanone, or cyclohexanone.

In yet another embodiment, the organic species may be a linear or a branched aldehyde having the formula C_{y}H_{2y}O, a cyclic aldehyde having the formula C_{y}H_{(2y-2)}O, wherein y is a number ranging from 1 to 7. Specific examples of aldehydes having either formula include formaldehyde or acetaldehyde.

In a still further embodiment, the organic species may be a linear or branched ether having the formula CᵥH₍₂ᵥ₊₂₎O, a cyclic ether having the formula CᵥH₂ᵥO, wherein v is a number ranging from 2 to 6. Specific examples of ethers having either formula include diethylether or tetrahydrofuran.

In another embodiment, the organic species may be a carboxylic acid having the chemical formula CₓH₂ₓO₂, wherein x is a number ranging from 1 to 6. Specific examples of carboxylic acids having this formula include formic acid, acetic acid, and propanic acid.

In a still further embodiment, the organic species may be a linear or a branched ester having the formula CᵥH₂ᵥO₂, a cyclic ester having the formula CᵥH₍₂ᵥ₋₂₎O₂, and mixtures thereof wherein v is a number ranging from 2 to 6. Specific examples of esters having either formula include methylformate, methylacetate, ethylformate, and ethylpropionate.

In yet another embodiment, the organic species may be a linear or branched acid anhydride having the formula CᵥH₍₂ᵥ₋₂₎O₃, a cyclic acid anhydride having the formula CᵥH₍₂ᵥ₋₄₎O₃, where v is a number ranging from 2 to 6. Specific examples of acid anhydrides having either formula include acetic anhydride and propionic andydride.

In one embodiment, the organic species may be a linear or branched diketone having the formula C_{w}H_{(2w-2)}O₂, a cyclic diketone having the formula C_{w}H_{(2w-4)}O₂, where w is a number ranging from 5 to 7. A specific example of a diketone having either formula includes acetoacetonate.

In certain embodiments, the cleaning composition comprises a diluent gas. In these embodiments, the diluent gas, may include, e.g., one or more inert gases such as He, Ar, N₂, Kr, and Xe. In these embodiments, particularly in cleaning compositions that contain organic species, the diluent gas is added to the cleaning composition in an amount sufficient to bring the composition below the lower explosive limit or above the upper explosive limit. In alternative embodiments, the cleaning conditions (e.g., gas flow rate, pressure, temperature, etc.) could also be varied to avoid explosive or flammable limits.

The cleaning composition is added to the chamber, preferably under pressure and temperature conditions substantially similar to the conditions under which processing (e.g., film deposition, annealing, etc.) is conducted. In the chamber, the cleaning composition is exposed to one or more energy sources to activate the cleaning composition and generate active species. The term active species, as used herein, refers to species present in either the gas phase and/or in the residue to be removed and includes, but is not limited to, ions, radicals, energetic neutrals, electrons, photons, etc. The active species then react with the residue to form volatile species that can be removed from the chamber. The energy source can be located inside and/or outside of the chamber. Examples of suitable energy source include, but are not limited to, thermal energy, a RF generated plasma energy, a remote RF plasma energy source, an electron beam energy source, a microwave energy source, a UV light energy source, and/or any of the other energy sources described herein.

In embodiments wherein the energy source comprises UV light, the UV light may be passed through the window for processing and/or cleaning purposes. In these embodiments, the window may be made of a material that has high transmittance of UV light in the 180 to 300 nm region. Example of suitable materials for the window include, but are not limited to, silica, synthetic silica, magnesium fluoride, calcium fluoride, and sapphire. In these embodiments, the ultraviolet light that is used to activate the cleaning composition may have a power density of 1 W/cm² or greater. However, in other embodiments, substantially lower power densities may be used.

In certain embodiments, a reflective substrate may be used to assist in the cleaning process. The reflective substrate is located in close proximity internal to or external to the chamber and is configured such that at least a portion of the ultraviolet light passing through the window is reflected to increase the intensity inside the chamber resulting from the back-reflection of the UV light. In one embodiment, the reflective substrate is provided below the window and within the chamber. In an alternative embodiment, the reflective substrate may be outside the chamber, particularly in combination with an energy source located in the chamber. The reflective substrate may be comprised of any material suitable for providing the desired reflectivity, durability and inertness. Examples of suitable reflective substrates include, but are not limited to, a bare silicon wafer, a metal mirror surface, or a metal mirror deposited onto a silicon substrate.

In the process described herein, the cleaning composition may be introduced at a wide range of pressures. The cleaning composition may be introduced at a pressure ranging from complete vacuum up to the highest pressure the chamber can withstand. In certain embodiments, the pressure may range from 1 torr to 760 torr (atmospheric pressure), or 760 Torr or less, or 500 Torr or less. In one particular embodiment, the cleaning composition is held in the chamber under static vacuum. In an alternative embodiment, the cleaning composition is allowed to flow through the chamber under a specified pressure.

The process described herein may be at a cleaning temperature of 500°C or less, or 350°C or less, or 200°C or less.

In one particular embodiment, the cleaning composition is introduced into the chamber at substantially the same pressure and temperature as the process preceding and/or following the cleaning method. For example, an inorganic/organic composite film may be processed or annealed to remove the porogen contained therein thereby forming a residue. The method to remove the residue may be conducted at substantially the same temperature and/or pressure as the annealing step.

The length of time the UV radiation is applied to the cleaning composition in the chamber depends on the efficiency of the cleaning composition, the thickness of the residue to be removed, and the temperature and pressure in the chamber. Although the duration of irradiation is not particularly limited thereto, in certain embodiments, the UV radiation is applied to the cleaning composition for a period of time ranging from second to minutes. Higher efficiencies, higher temperatures and higher pressures may require shorter periods of irradiation to remove the residue. In one embodiment, the irradiating is conducted within a time span not greater than one hour. In another, the time span is not more than ten minutes. Finally, in another the time span is not more than ten seconds.

The method will be illustrated in more detail with reference to the following Examples, but it should be understood that the method is not deemed to be limited thereto.

### EXAMPLES

Comparative examples 1 through 3 and examples 4 through 17 were conducted in the following manner. In these examples, the reaction chamber was a cylindrical quartz tube which is 2" diameter x 8" length x 1/8" thickness. UV light was introduced into the quartz tube using a Fusion UV model F305 ultraviolet lamp equipped with a 558431-H⁺ bulb, that provided UV radiation at wavelengths ranging from 200 to 450 nm. The F300 lamp has an emission footprint of 6"x4" with a power output of 1800 watts (12 W/cm²). The lamp-to-sample distance was 4". Composite films of organic and organosilicate were deposited onto silicon wafers and then broken into smaller pieces (3 cm x 5 cm) and placed inside the quartz tube with sealed o-ring end caps attached to either vacuum or nitrogen purge. Vacuum (5-20 millitorr) was maintained using a Franklin Electric ¾-horsepower wet roughing pump. In examples involving a vacuum or inert atmosphere, three pump and purge cycles were performed prior to UV exposure to ensure that residual oxygen within the sample tube was below 50 ppm. During each exposure of a composite film, a thin film of residue is deposited onto the inside of the quartz tube.

The optical transmission through the quartz tube was measured by placing the quartz tube between two optical fibers. One optical fiber was connected to an OceanOptics broadband UV light source to provide a reference source. A neutral density filter was placed in front of the fiber opposite the reference source. An OceanOptics spectrophotometer was used to measure the UV transmission through the quartz tube at the opposite fiber. In this way, changes in the transmission properties of the quartz tube can be measured.

The UV absorbance of the residue on the inside of the tube is measured ex-situ by placing the tube into the stand in a vertical position with the UV beam passing though the tube along the same path traversed by the UV light in the annealing experiment, e.g. perpendicular to the axis of the tube and to the position in which the samples for irradiating were placed. To test the effectiveness of various in-situ tube cleaning methods, the following protocol was followed. First, the quartz tube was cleaned and UV transmission through the tube was measured as a reference. The tube was then installed in the annealing apparatus and a sample of the composite film deposited on a silicon wafer (approximately 1" wide by 8" long) was annealed. The composite film was deposited via PECVD from a 70/30 blend of limonene and diethoxymethylsilane (see copending U.S. Patent Application Publications Nos. 2004/0096672 and 2004/0096593). After annealing, the sample was removed and the UV transmission spectra were taken. The intensity of this spectra was compared to the original reference to measure the amount of absorption resulting from residue deposited on the inside of the reaction chamber. The quartz tube was then reassembled and the desired experimental in-situ chamber cleaning procedure conducted. When a cleaning composition containing an organic species and a oxidizing gas was introduced, the quartz tube was first pumped down and then backfilled with 2 Torr of organic species followed by the desired amount of an oxidizing gas. Once the desired cleaning composition was achieved, the UV lamp was turned on while the reaction chamber was maintained under a static pressure. After a certain length of exposure time, the quartz tube was cooled and the UV transmission spectrum was re-measured.

### Examples 1-11

Comparative Examples 1-3 and Examples 4-11 were conducted using the experimental set-up described above using various cleaning compositions, pressures, and cleaning times as shown in Table I. Table I also discloses the transmission of the clean quartz tube, the transmission of the reaction chamber after anneal, and after clean, and the percent recovery of transmission at 273 nm.

Comparative Examples 1 and 2 show the effectiveness of air as the cleaning composition to remove the residue from the reaction chamber. As the results in Table 1 illustrate, air in the presence of UV light slowly removes the organic residue from the reaction chamber; however, this requires up to 10 minutes of cleaning time.

Comparative Example 3 shows the effective of a cleaning composition including isopropyl alcohol (IPA) and the diluent gas nitrogen which is not an oxidizing gas in removing the organic residue. Table 1 shows that after 5 minutes of exposure to a cleaning composition of IPA and nitrogen, there is no change in the UV transmission through the reaction chamber.

Examples 4 through 11 represent exemplary cleaning compositions that include IPA and air at various concentrations, pressures, and exposure times. The chamber pressures in Examples 4, 5, and 6 are the same as those of Examples 1 and 2, but with 0.5 molar % IPA added. Referring to Example 4, the use of a cleaning composition containing 0.5% IPA completely removed the residues formed during annealing in 1 minute of cleaning. This represents a greater than 100% increase in the removal rate enhancement of the organic residue by addition of just 0.5% IPA into air. Examples 7 through 11 represent additional experiments in which the chamber pressure is lowered as the percent IPA concentration is increased. For all of the Examples using IPA and air, the residue is completely removed after three minutes of exposure or less.

**Table 1: UV transmission data for the in-situ chamber cleaning experiments with the quartz tube.**

| Ex. # | Cleaning Comp. | Total Press. (torr) | Clean Time (min.) | Transmission of Clean Quartz tube | Transmission After anneal | Transmission After clean | Percent recovery of transmission at 273 nm |
|---|---|---|---|---|---|---|---|
| 1 | Air | 400 | 5 | 1931 | 1560 | 1750 | 51 |
| 2 | Air | 400 | 10 | 2000 | 1488 | 2003 | 100+ |
| 3 | 2 Torr IPA in N₂ | 400 | 5 | 2080 | 1540 | 1510 | -6 |
| 4 | 2 Torr IPA in air | 400 | 0.5 | 1451 | 1027 | 1262 | 55 |
| 5 | 2 Torr IPA in air | 400 | 1 | 1995 | 1502 | 1974 | 96 |
| 6 | 2 Torr IPA in air | 400 | 5 | 1917 | 1591 | 2065 | 100+ |
| 7 | 2 Torr IPA in air | 200 | 1 | 1818 | 1118 | 1432 | 45 |
| 8 | 2 Torr IPA in air | 200 | 2 | 1528 | 1030 | 1560 | 100+ |
| 9 | 2 Torr IPA in air | 200 | 3 | 1840 | 1388 | 1822 | 96 |
| 10 | 2 Torr IPA in air | 100 | 1 | 1890 | 1318 | 1644 | 57 |
| 11 | 2 Torr IPA in air | 100 | 3 | 1883 | 1205 | 1893 | 100+ |

### Examples 12-17

Examples 12-17 were conducted using the experimental set-up described above. In these examples, residues were removed using UV light and a cleaning compositions containing air and 2 Torr of an organic species selected from ethanol (EtOH), acetone or isopropyl alcohol (IPA) to determine if there was a dependence on the organic species within the cleaning composition. The process parameters and the results of these experiments are provided in Table 2. The data shown in Table 2 taken together with the results from experiments 7 and 8 in Table 1 illustrate that the acetone clean proceeded most rapidly followed by ethanol and IPA. However, all of them are significantly faster than air alone.

**Table 2: UV transmission data for the in-situ chamber clean experiments comparing IPA, ethanol, and acetone, with the quartz reactor.**

| Ex. # | Cleaning Comp. | Total Press. (torr) | Clean Time (min.) | Transmission of Clean quartz tube | Transmission After anneal | Transmission After clean | Percent recovery of transmission at 273 nm |
|---|---|---|---|---|---|---|---|
| 12 | 2 Torr IPA in air | 200 | 3 | 1840 | 1388 | 1822 | 96 |
| 13 | 2 Torr EtOH in air | 200 | 1 | 1645 | 1234 | 1550 | 77 |
| 14 | 2 Torr EtOH in air | 200 | 1.5 | 1525 | 963 | 1491 | 94 |
| 15 | 2 Torr EtOH in air | 200 | 2 | 1550 | 1114 | 1584 | 100+ |
| 16 | 2 Torr acetone air | 200 | 1 | 1724 | 1169 | 1640 | 85 |
| 17 | 2 Torr acetone in air | 200 | 3 | 1703 | 1233 | 1742 | 100+ |

### Example 18

In this example, the reaction chamber used was an Applied Materials DxL lamp heated vacuum deposition chamber modified with a ½"-thick synthetic silica window in the lid. This reaction chamber was able to process 200 mm silicon wafers. The UV light source was a Fusion UV 1600 lamp placed above the chamber. The 1600 is a variable power lamp with a 10"x4" emission footprint. Its full power output is 6000 watts (24 W/cm²), and it was also fitted with an H⁺ bulb. Curing uniformity across a 200mm diameter wafer was improved by sweeping the linear 10" bulb across the wafer using an electric motor to move the lamp. Wafer temperature was controlled in this apparatus by an infrared (IR) lamp heater positioned below the susceptor. Inert purge gases were delivered through a mass flow controller (20L full range), and vacuum was maintained using a BOC Edwards QDP 40 pump and throttle valve attached to the chamber. This chamber was also modified with an in-situ UV optical fiber so that the UV transmission through the silica lid can be measured. In this way, direct measurements of the effect of porogen residue buildup on the transmission window can be made.

Table 3 presents a series of 200 mm wafers with 1 micron thick composite films of porogen plus OSG, which were run sequentially in the UV anneal chamber. All samples were exposed to 24 W/cm² UV light for 10 minutes. The initial wafer temperature for each anneal was 200°C, the chamber pressure was 3 Torr and there was a 25 standard cubic centimeters per minute (sccm) helium purge during annealing. It can be seen from Table 3 that the percent film shrinkage, percent porogen removal, and film hardness/modulus continually decreased with the number of wafers processed. This indicates that the porogen build-up affects the UV transmission such that even after one wafer processed the window needs to be cleaned. By way of comparison, manual cleaning of the transmission window entails opening the chamber and cleaning with solvents and/or abrasives which may require at least 60 minutes to complete.

**Table 3: Series of Wafers with 1 micron thick residue run sequentially in UV chamber**

| No. of Wafers Processed | RI | Shrinkage (%) | Porogen Removal (% by FT-IR) | H (GPa) | Mod (GPa) |
|---|---|---|---|---|---|
| 0 (as deposited) | 1.445 | 0 | 0 | 0.88 | 6.72 |
| 1 | 1.365 | 6.5 | 100 | 1.1 | 6.81 |
| 2 | 1.360 | 5.1 | 92 | - | - |
| 3 | 1.358 | 4.5 | 92 | 0.96 | 6.11 |
| 4 | 1.360 | 3.2 | 70 | - | - |
| 5 | 1.363 | 3.0 | 84 | 0.88 | 5.75 |

UV transmission spectra were taken and analyzed. Compare to the UV transmission spectrum obtained of a clean transmission window, the UV spectrum taken after annealing a 1 micron porogen plus OSG composite film showed significant absorption at wavelengths below 500 nm. However, the UV spectrum taken after cleaning the window in-situ for 25 minutes in a cleaning composition comprising 500 Torr of O₂ with the UV light at 100% power and sweeping was substantially the same as the UV spectra obtained of the clean transmission window.

### Examples 19-25

Table 4 summarizes a series of experiments to minimize the in-situ clean time using the same reaction chamber described in Example 18. In these experiments, the transmission intensity of the UV light passing through the clean silica window is measured followed by exposure of a 1 micron thick composite film under the following conditions: 10 minutes at 3 Torr with 500 sccm helium purge and a starting temperature of 300°C. The substrate is then removed from the chamber and the transmission spectrum is measured to determine the attenuation of the UV light by residue build-up. Oxygen is introduced into the chamber to a pre-determined pressure and held under static pressure during the cleaning experiments. The UV lamp is turned on and the in-situ UV spectrometer is used to monitor the transmission of the window as a function of cleaning time. The chamber clean is considered complete when the UV spectrum is essentially identical to that measured prior to the UV annealing of the composite film.

**Table 4: Cleaning conditions and times for removing residues from the silica window used for 200 mm substrates.**

| Example | Condition | Clean Time |
|---|---|---|
| 19 | 10 Torr O₂, lamp in fixed position | > 1 hour |
| 20 | 95 Torr O₂, lamp in fixed position | 1 hour |
| 21 | 350 Torr O₂. lamp in fixed position | 40 minutes |
| 22 | 350 Torr O₂, lamp swept | 30 minutes |
| 23 | 500 Torr O₂, lamp swept | 25 minutes |
| 24 | 500 Torr O₂, lamp swept, refractive substrate (e.g., silicon wafer) in chamber | 15 minutes |
| 25 | 500 Torr O₂, lamp swept, refractive substrate (e.g., aluminum coated silicon wafer) in chamber | 10 minutes |

In Examples 19, 20, and 21, the UV lamp is held in a fixed position and not swept across the transmission window. This series of experiments shows that as the O₂ pressure is increased, the time to clean the chamber is shortened from >60 minutes to 40 minutes.

In Examples 22 and 23, the UV lamp is swept back and forth across the transmission window. Example 22 indicates that the sweeping motion shortens the cleaning time. Presumably, this occurs because the UV light is most intense directly below the lamp bulb, as the lamp is swept across the window more area is exposed to the high intensity UV light. Example 23 reinforces the observation that higher levels of O₂ may shorten the clean time

In Examples 24 and 25, a reflective substrate is placed inside the chamber under the transmission window after the wafer with the UV treated film on it is removed. The data in Table 4 illustrates that the presence of a reflective substrate, such as the silicon wafer or the aluminum coated silicon wafer in Examples 24 and 25, respectively, improved cleaning efficiency. In Examples 24 and 25, it is believed that the cleaning time decreased with the reflective surface due to an increase in the light intensity inside the chamber resulting from the back-reflection of the UV light.

While the method has been described in detail and with reference to specific examples thereof, it will be apparent to one skilled in the art that various changes and modifications can be made therein without departing from the spirit and scope thereof.

## Claims

1. A method for removing a residue from a surface, said method comprising:
providing a chamber containing the surface coated with the residue;
introducing into the chamber a cleaning composition comprising an oxidizing gas, an organic species, and optionally a diluent gas; and
exposing at least a portion of the cleaning composition to an energy source comprising ultraviolet light to provide active species wherein the active species react with at least a portion of the residue and remove the residue from the surface.

2. The method of claim 1, wherein the organic species comprises one selected from methanol, ethanol, isopropanol, acetone, methylethylketone, cyclopentanone, cyclohexanone, formaldehyde, acetaldehyde, diethylether, tetrahydrofuran, formic acid, acetic acid, propanoic acid, methylformate, methylacetate, methyl propionate, ethylacetate, ethylformate, ethylpropionate, acetic anhydride, propionic andydride, acetoacetonate and mixtures thereof.

3. The method of claim 1, wherein the organic species comprises one selected from a hydrocarbon, an alcohol, a ketone, an aldehyde, an ether, a carboxylic acid, an ester, an acid anhydride, a diketone, and mixtures thereof.

4. The method of claim 3, wherein the organic species is the alcohol selected from a linear or branched alcohol having the formula CₓH₍₂ₓ₊₂₎O, a cyclic alcohol having the formula CₓH₂ₓO, and mixtures thereof wherein x is a number ranging from 1 to 6.

5. The method of claim 3, wherein the organic species is the ketone selected from a linear or branched ketone having the formula CᵤH₂ᵤO, a cyclic ketone having the formula CᵤH₍₂ᵤ₋₂₎O, and mixtures thereof wherein u is a number ranging from 3 to 6.

6. The method of claim 3, wherein the organic species is the aldehyde selected from a linear or a branched aldehyde having the formula C_{y}H_{2y}O, a cyclic aldehyde having the formula C_{y}H_{(2y-2)}O, and mixtures thereof wherein y is a number ranging from 1 to 7.

7. The method of claim 3, wherein the organic species is the ether selected from a linear or branched ether having the formula CᵥH₍₂ᵥ₊₂₎O, a cyclic ether having the formula CᵥH₂ᵥO, and mixtures thereof wherein v is a number ranging from 2 to 6.

8. The method of claim 3, wherein the organic species is the carboxylic acid represented by the formula CₓH₂ₓO₂, wherein x is a number ranging from 1 to 6.

9. The method of claim 1, wherein the organic species is the ester selected from a linear or a branched ester having the formula CᵥH₂ᵥO₂, a cyclic ester having the formula CᵥH₍₂ᵥ₋₂₎O₂, and mixtures thereof wherein v is a number ranging from 2 to 6.

10. The method of claim 1, wherein the organic species is the acid anhydride selected from a linear or branched acid anhydride having the formula CᵥH₍₂ᵥ₋₂₎O₃, a cyclic acid anhydride having the formula CᵥH₍₂ᵥ₋₄₎O₃, and mixtures thereof wherein v is a number ranging from 2 to 6.

11. The method of claim 1, wherein the organic species is the diketone selected from a linear or branched diketone having the formula C_{w}H_{(2w-2)}O₂, a cyclic diketone having the formula C_{w}H_{(2w-4)}O₂, and mixtures thereof wherein w is a number ranging from 5 to 7.

12. The method of claim 1, wherein the oxidizing gas comprises air.

13. The method of claim 1, wherein the oxidizing gas comprises one selected from O₂, N₂O, NO₂, NO, CIF₃, CF₂(OF)₂, NF₃, O₃, and mixtures thereof.

14. The method of claim 1, wherein the cleaning composition comprises the diluent gas.

15. The method of claim 1, further comprising processing an article within the chamber to form the residue on the surface wherein a temperature of exposing and processing is substantially the same.

16. The method of claim 15, wherein the temperature is 500°C or less.

17. The method of claim 1, further comprising processing an article within the chamber to form the residue on the surface wherein a pressure of exposing and processing is substantially the same.

18. The method of claim 17, wherein the pressure is 760 Torr or less.

19. The method of claim 1, wherein the surface coated with the residue is a transmission window comprising at least one of silica, synthetic silica, magnesium fluoride, calcium fluoride, and sapphire, the exposing comprises passing ultraviolet light though the transmission window into the chamber wherein the ultraviolet light has a power density greater than 1 W/cm².

20. The method of claim 1, wherein the surface coated with the residue is a transmission window, and a reflective substrate is placed in the chamber under the transmission window to reflect at least a portion of the ultraviolet light that has passed through the transmission window back to the transmission window.

21. The method of claim 20, wherein the reflective substrate is selected from a bare silicon wafer, a metal mirror surface, and a metal mirror deposited onto a silicon substrate.

22. The method of claim 1, wherein the residue is a byproduct of annealing an inorganic/organic composite within the chamber, the surface is a transmission window, and the residue is removed from the surface sufficiently to permit further performance of annealing.

23. A method for removing a residue from a surface of a window of a chamber, said method comprising:
providing the chamber comprising the window with the surface having the residue and a reflective substrate that is located in close proximity to the chamber;
introducing into the chamber a cleaning composition comprising an oxidizing gas, optionally an organic species, and optionally a diluent gas; and
passing ultraviolet light through the window and onto the reflective substrate such that at least a portion of the ultraviolet light passing through the window is reflected back to the transmission window wherein the ultraviolet light activates the cleaning composition to form active species which react with the residue so as to remove the residue from the surface.

24. The method of claim 23, wherein the organic species is represented by a chemical formula selected from the group consisting of: a linear or branched alcohol having the formula CₓH₍₂ₓ₊₂₎O, a cyclic alcohol having the formula CₓH₂ₓO, a linear or branched ketone having the formula CᵤH₂ᵤO, a cyclic ketone having the formula CᵤH₍₂ᵤ₋₂₎O, a linear or a branched aldehyde having the formula C_{y}H_{2y}O, a cyclic aldehyde having the formula C_{y}H_{(2y-2)}O, a linear or branched ether having the formula CᵥH₍₂ᵥ₊₂₎O, a cyclic ether having the formula CᵥH₂ᵥO, the carboxylic acid represented by the formula CₓH₂ₓO₂, a linear or a branched ester having the formula CᵥH₂ᵥO₂, a cyclic ester having the formula CᵥH₍₂ᵥ₋₂₎O₂, a linear or branched acid anhydride having the formula CᵥH₍₂ᵥ₋₂₎O₃, a cyclic acid anhydride having the formula CᵥH₍₂ᵥ₋₄₎O₃, a linear or branched diketone having the formula C_{w}H_{(2w-2)}O₂, a cyclic diketone having the formula C_{w}H_{(2w-4)}O₂, where w is 5 to 7, and mixtures thereof,
wherein x is a number ranging from 1 to 6, u is a number ranging from 3 to 5, v is a number ranging from 2 to 6, y is a number ranging from 1 to 7, and w is a number ranging from 5 to 7.

25. The method of claim 24, wherein the organic species comprises at least one member selected from the group consisting of methanol, ethanol, isopropanol, acetone, methylethylketone, cyclopentanone, cyclohexanone, formaldehyde, acetaldehyde, diethylether, tetrahydrofuran, formic acid, acetic acid, propanoic acid, methylformate, methylacetate, methyl propionate, ethylacetate, ethylformate, ethylpropionate, acetic anhydride, propionic andydride and acetoacetonate.

26. The method of claim 23, wherein the oxidizing gas comprises at least one member selected from the group consisting of O₂, N₂O, NO₂, NO, CIF₃, CF₂(OF)₂, O₃, NF₃, and mixtures thereof.

27. The method of claim 23, wherein the window comprises at least one of silica, synthetic silica, magnesium fluoride, calcium fluoride and sapphire.

28. The method of claim 23, wherein the reflective substrate is selected from a bare silicon wafer, a metal mirror surface, and a metal mirror deposited onto a silicon substrate.

29. The method of claim 23 wherein the reflective substrate is located in the chamber under the window.

30. The method of claim 23, wherein the residue is provided on the surface as a byproduct of annealing an inorganic/organic composite within the chamber, and the residue is removed from the surface sufficiently to permit further performance of the annealing.

31. The method of claim 23 wherein the cleaning composition comprises the diluent gas.

32. A method for removing a residue from a surface, said method comprising:
providing a chamber containing the surface coated with the residue;
introducing into the chamber a cleaning composition comprising an oxidizing gas, an organic species, and optionally a diluent gas; and
exposing at least a portion of the cleaning composition to an energy source to provide active species wherein the active species react with at least a portion of the residue and remove the residue from the surface.

33. The method of claim 32 wherein the energy source is selected from thermal energy, RF generated plasma energy, remote RF plasma energy source, an electron beam, a microwave, ultraviolet light, and mixtures thereof.

34. A cleaning composition for removing a residue from a surface comprising:
an oxidizing gas, an organic species, and a diluent gas.
